(19) Europäisches Patentamt
European Patent Office
Office européen des brevets

(11) EP 3 710 542 B1

(12) EUROPEAN PATENT SPECIFICATION

(45) Date of publication and mention of the grant of the patent:
**05.01.2022 Bulletin 2022/01**

(21) Application number: **18800959.1**

(22) Date of filing: **15.11.2018**

(51) Int Cl.:
***C09D 153/00*** (2006.01) ***C09D 5/02*** (2006.01)
***G03F 7/00*** (2006.01) ***G02B 5/22*** (2006.01)
***C08F 297/02*** (2006.01) ***C09D 7/45*** (2018.01)
***G03F 7/033*** (2006.01)

(86) International application number:
**PCT/EP2018/081349**

(87) International publication number:
**WO 2019/096893 (23.05.2019 Gazette 2019/21)**

# (54) BLOCK CO-POLYMER

BLOCKCOPOLYMER

COPOLYMÈRE SÉQUENCÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.11.2017 EP 17201870**

(43) Date of publication of application:
**23.09.2020 Bulletin 2020/39**

(73) Proprietor: **BYK-Chemie GmbH**
**46483 Wesel (DE)**

(72) Inventors:
- **OKKEL, Andreas**
  **46483 Wesel (DE)**
- **FRANK, Albert**
  **46483 Wesel (DE)**
- **YONEHARA, Hiroshi**
  **46483 Wesel (DE)**

(74) Representative: **Altana IP Department**
**Altana Management Services GmbH**
**Abelstraße 45**
**46483 Wesel (DE)**

(56) References cited:
**EP-A1- 0 556 649**
**EP-A1- 3 147 335**
**WO-A1-2010/059939**
**WO-A2-2009/076567**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 710 542 B1

## Description

The invention relates to a block co-polymer, to a composition comprising the block co-polymer, and to a process for preparing a color filter.

JP 2009-25813 describes the use of aminic block co-polymers, consisting of acrylic esters and/or methacrylic esters, for the preparation of color resists, with an amine value in the range from 80 mg KOH/g to 150 mg KOH/g. The use of these co-polymers as dispersants leads to a slow removal of the non-cured coating in the developing step. US 5,272,201 describes the use of methacrylate block co-polymers, which are prepared by means of GTP (Group Transfer Polymerization) and comprise an aminic monomer in one block and an acidic monomer in the other block, as wetting agents and dispersants for aqueous inkjet inks.

In EP 2 589 614 pigmented UV-sensitive formulations with AB diblock co-polymer dispersants that contain at least one tertiary amino group and/or quaternary ammonium salt group as pigment affinic groups in one block and up to 10 mol-% monomers that contain a carboxylic acid group in the other block, are described.

JP-A-2013053231 describes a process of preparing AB diblock co-polymers by means of GTP formed from monomers consisting of acrylic esters and/or methacrylic esters in one block and acrylic esters and/or methacrylic esters bearing at least one amino group in the other block.

Some coating materials are used as color filters in liquid-crystal screens and liquid-crystal displays (LCDs). In this field of application in particular, stringent requirements are imposed on the coloristic properties of the coating material and on its processing properties. In order to attain these stringent requirements, wetting agents and dispersants are used which produce a storage-stable pigment dispersion having a Newtonian flow behavior and a moderate viscosity. Furthermore, the color filter pattern is produced with a photolithographic procedure. In this process, the whole panel is coated with the liquid color resist by spin or slid coating. After drying of the coating, the pixel pattern of the color is created by UV-curing of certain parts of the panel using a photo mask and removing the non-cured coating with a developer, which is a basic aqueous solution that also contains surface-active substances. In this step, the color resist has to become water-soluble. The wetting and dispersing agent may not negatively influence this developing step, for example by lengthening the process time or by causing coating particles left on the panel.

There is an ongoing need for improved polymers suitable as wetting and dispersing agents, which produce in particular a low-viscosity, storage-stable pigment concentrate, in particular in the field of color filters for liquid crystal displays. A low viscosity of the pigment concentrate and of the coating material is needed for the application of the coating material to the substrate. If the pigment dispersions are not storage-stable and agglomerate, the contrast is impaired. In particular, there is a need for co-polymers that have a low intrinsic color, in particular when used as wetting agents or dispersants. Moreover the wetting and dispersing agent should have no negative influence on the developing step as for modern color filters the pigment loading is increased and therewith the amount of wetting and dispersing additive which is used in the formulation, too. The co-polymer suitable as wetting and dispersing agent should furthermore exhibit a broad compatibility with a variety of other components, such as resins, of compositions wherein it is used.

The invention provides a block co-polymer comprising at least one first block and at least one second block which is different from the first block, wherein the first block comprises repeating units 1,

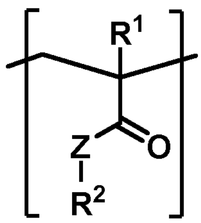

repeating unit 1 and the second block comprises repeating units 2,

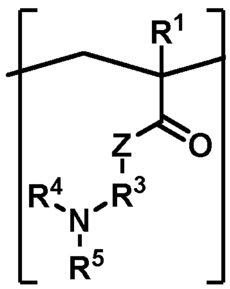

repeating unit 2 wherein

Z represents O or NH,
$R^1$ represents H or $CH_3$,
$R^2$ represents a group selected from hydrocarbyl groups and ether group-containing groups,
$R^3$ represents an organic group having 2 to 4 carbon atoms,
$R^4$ and $R^5$ independently represent an organic group, wherein $R^4$ and $R^5$ are optionally linked to each other to form a cyclic structure,
and wherein the first block comprises at least two different types of repeating units comprising ether groups.

It should be understood that ether groups generally relate to non-cyclic ether groups. The block co-polymer of the invention is very suitable as wetting and dispersing agent. It is suitable for producing low viscosity and storage stable pigment dispersions and pigment concentrates.

The first block of the block co-polymer comprises repeating units 1 as described above. According to the invention, the first block comprises at least 2 different types of repeating units 1 comprising ether groups. Generally, the first block comprises 3 to 12 different types of repeating units 1. The repeating units 1 in the block co-polymer are generally derived by polymerization of suitable ethylenically unsaturated polymerizable monomers.

The ethylenically unsaturated monomers that form the repeating unit 1 in the block co-polymer are generally selected from acrylic esters, methacrylic esters, acrylamides and/or methacrylamides which preferably carry no primary, secondary, tertiary or quaternized amino group. Herein the term "(meth)acryl" refers to both methacryl and acryl. The same applies for the term "(meth)acrylate" which refers to both methacrylate and acrylate, likewise.

Examples for such monomers are:

(i) (meth)acrylic esters of straight-chain, branched or cycloaliphatic alcohols having 1 to 22, preferably 1 to 12, more preferably 1 to 8 and most preferably 1 to 6 carbon atoms, such as methyl (meth)acrylate, ethyl (meth)acrylate, n-butyl (meth)acrylate, tert-butyl (meth)acrylate, n-hexyl (meth)acrylate, isobutyl (meth)acrylate, isopentyl (meth)acrylate, lauryl (meth)acrylate, 2-ethylhexyl (meth)acrylate, stearyl (meth)acrylate, cyclohexyl (meth)acrylate, behenyl (meth)acrylate, isodecyl (meth)acrylate, 2-propylheptyl (meth)acrylate, 3,5,5-trimethyl-1-hexyl (meth)acrylate, nonanyl (meth)acrylate, 2-propylheptyl (meth)acrylate, 2-isopropyl-5-methylhexyl (meth)acrylate, tridecyl (meth)acrylate, heptadecyl (meth)acrylate, heneicosanyl (meth)acrylate and isobornyl (meth)acrylate; and

(ii) aryl (meth)acrylic esters whose aryl ring, without possible additional substituents, contains 5 to 12, preferably 6 to 10, carbon atoms, such as phenyl acrylate; and aralkyl (meth)acrylic esters whose aralkyl radical, without possible additional substituents on the aryl radical, contains 6 to 11, preferably 7 to 11, carbon atoms, such as benzyl methacrylate, it being possible for the aryl radicals of the aryl (meth)acrylic esters and of the aralkyl (meth)acrylic esters in each case to be unsubstituted or to be substituted up to four times, such as, for example, 4-methylphenyl methacrylate; and

(iii) (meth)acrylic acid esters of monoether monoalcohols or polyether monoalcohols, such as ethers, polyethylene glycols, polypropylene glycols, polybutylene glycols or mixed polyalkylene glycols having 4 to 80 carbon atoms and a statistical, a block or a gradient distribution of the different monomers along the chain, such as, for example, tetrahydrofurfuryl (meth)acrylate, di(ethylene glycol) methyl ether (meth)acrylate, furfuryl (meth)acrylate, 2-butoxyethyl (meth)acrylate, 2-ethoxyethyl (meth)acrylate, allyloxyethyl (meth)acrylate, 1-ethoxybutyl (meth)acrylate, methyltriglycol (meth)acrylate, ethyltriglycol (meth)acrylate, butyldiglycol (meth)acrylate, poly(propylene glycol) methyl ether (meth)acrylate and poly(ethylene glycol) alkyl ether (meth)acrylate, wherein alkyl stands for a straight-chain or branched alkyl residue having 1 to 22, preferably 1 to 15, more preferably 1 to 13, even more preferably 1 to 10 carbon atoms and most preferable 1 to 7 carbon atoms; and

(iv) trimethylsilyl(meth)acrylate.

Preferred are esters of methacrylic acid, rather than esters of acrylic acid. More preferably $R^2$ in repeating unit 1 stands for a branched or unbranched alkyl residue with 1 to 12, preferably 1 to 10 carbon atoms, a cycloalkyl residue with 4 to 8, preferably 6 carbon atoms, an araliphatic residue with 7 to 12 carbon atoms, like benzyl; and trimethylsilyl.

Highly preferred are methyl and butyl methacrylate, cyclohexyl methacrylate, isobornyl methacrylate and polyalkylenoxide methacrylates.

As mentioned above, the first block comprises at least two types of repeating units 1 comprising ether groups. Such repeating units are suitably provided by monomers of the following formula (I)

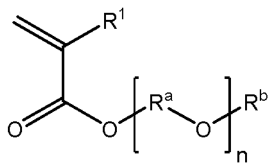

(I)

wherein

$R^1$ represents H or $CH_3$,
$R^a$ represents a linear or branched alkylene group with 2 to 6 carbon atoms,
$R^b$ represents aralkyl, preferably benzyl; or alkyl with 1 to 8 carbon atoms, preferably methyl, ethyl, propyl or butyl; and
n represents an integer from 1 to 150, preferably 1 to 50, more preferably 1 to 25,
and in case at least two different types of residue $R^a$ are present the n [$R^a$O] units, the $[R^aO]_n$ chain may have a random, block or gradient architecture along the chain.

It should be noted that repeating units which have a molecular weight distribution, but which are otherwise chemically uniform, are counted as one type of repeating unit for the purpose of determining the number of different types of repeating units in the first block. It should further be noted that for determining the number of different types of repeating units, low-level impurities, which may unintentionally be present in polymerizable monomers forming the repeating units, are disregarded. Generally, repeating units which represent less than 1.0 % by weight, calculated on the weight of the first block, are disregarded when determining the number of different types of repeating units in the first block.

The first block comprises at least two different types of repeating units comprising ether groups. Generally, first block comprises from 2 to 4 different types of repeating units comprising ether groups.

In a preferred embodiment, the first block comprises between 3 and 50 mol-% of repeating units comprising ether groups.

In a very preferred embodiment, the first block comprises repeating units derived from monomers selected from ethyl triglycol methacrylate, methyl triglycol methacrylate, butyl diglycol methacrylate, and mixtures thereof.

In preferred embodiments, the first block consists of polymerized units of one or more non-cyclic-alkyl methacrylates in an amount of 35 to 80 % by weight, one or more methacrylates of an alcohol having an aromatic or aliphatic ring in an amount of 3 to 25 % by weight and two or more methacrylates of an alcohol having ether groups in an amount of 3 to 40 % by weight, wherein the % by weight add up to 100%.

In a more preferred embodiment, the first block consists of polymerized units of a) methyl methacrylate in an amount of 20 to 60, particularly 30 to 50 % by weight, b) butyl methacrylate in an amount of 10 to 30, particularly 15 to 25 % by weight, c) 2-ethyl-hexyl methacrylate in an amount of 10 to 30, particularly 15 to 25 % by weight, d) one or more methacrylates of an alcohol having an aromatic or aliphatic ring in an amount of 3 to 20, particularly 6 to 14 % by weight, and e) two or more methacrylates of an alcohol having ether groups in an amount of 3 to 20, particularly 5 to 15 % by weight, wherein the % by weight of a) to e) add up to 100 %.

Repeating Unit 2

The second block of the co-polymer comprises repeating units 2 having a tertiary amino group. Repeating units 2 can be generated by polymerization of acrylic esters, methacrylic esters, acrylamides and methacrylamides which have at least one tertiary amino group. The monomers are preferably selected from the group of tert.-aminoalkyl (meth)acrylic esters having 2 to 12, preferably 2 to 8 carbon atoms in the tert.-aminoalkyl group, including possible additional substituents, like further additional tert.-amino groups in residues $R^4$ and $R^5$. Examples for repeating unit 2 are N,N-dimethylaminoethyl (meth)acrylate, N,N-diethylaminoethyl (meth)acrylate, N,N-dibutylaminoethyl (meth)acrylate, 2-(2-dimethylaminoethyl(methyl)amino]ethyl (meth)acrylate, 2-(2-dimethylaminoethyloxy)ethyl (meth)acrylate, 2-morpholinoethyl (meth)acrylate, 2-(1-piperidyl)ethyl (meth)acrylate, 2-(N-ethylanilino)ethyl (meth)acrylate, 2-imidazol-1-ylethyl (meth)acrylate and N,N-dimethylaminopropyl (meth)acrylate. Most preferred is the use of N,N-dimethylaminoethylmethacrylat (DMAEMA).

Repeatinq units 2 containing at least one tertiary amino group can also be produced by polymer-analoqous reactions after the construction of the polymer chain. By way of example, oxiran-containing ethylenically unsaturated monomers such as glycidyl methacrylate can be (co)polymerized to form a polymeric block having oxirane groups. They can be reacted with amines after the polymerization. In such case residue $R^3$ will contain a hydroxyl group. If desired, $R^4$ and/or $R^5$ may contain further hydroxyl groups. Suitable for this purpose are primary amines which additionally carry one or more tertiary amino groups or secondary amines, which optionally additionally carry one or more tertiary amino groups. Examples include dimethylaminopropylamine and diethylaminoethylamine; dialkylamines such as diethylamine, dibutylamine and dicyclohexylamine; secondary amines having two different substituents such as, for example, N-(2-hydroxyethyl)aniline; secondary amines which additionally carry one or more tertiary amino groups, such as bis(3-dimethylaminopropyl)amine; dihydroxy-alkylamines, such as diethanolamine and diisopropanolamine. Preference is given to secondary amines which, optionally, additionally carry one or more tertiary amino groups.

In a further embodiment, the second block further comprises repeating units 3

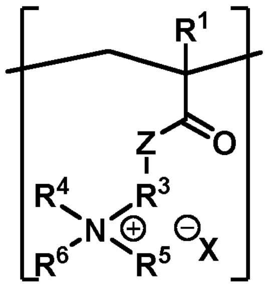 repeating unit 3

wherein $R^6$ represents an organic group and $X^-$ represents an anion.

Repeating units 3 can be described as reaction product of a quaternization reaction of the tertiary amine group of repeating units 2.

Thus, repeating units 3 can be introduced by partial quaternization of the amine groups of repeating units 2.

Suitable quaternization agents may be selected from alkyl halides and aralkyl halides, or epoxides, for example glycidyl ethers in the presence of acids. Typically, alkyl halides and aralkyl halides like benzyl chloride, 2- or 4-vinylbenzylchloride, methyl chloride or methyl iodide can be used. Moreover, tosylates like methyl tosylate can be used. Examples of suitable glycidyl ethers are alkyl glycidyl ethers like 2-ethylhexyl glycidyl ether and $C_{13}/C_{15}$-alkyl glycidyl ether or aryl glycidyl ethers like cresylglycidyl ether as well as glycidyl methacrylate. Examples for acids used in this quaternization reaction are carboxylic acids like benzoic acid, acetic acid or lactic acid. Further acids are phosphoric acid ester with one or two ester substituents. Preferred are benzyl chloride, 4-vinylbenzyl chloride and glycidyl methacrylate in combination with a carboxylic acid.

In a further embodiment, quaternization is carried out with a quaternization agent of formula (II)

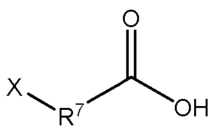

(II)

wherein X is a so-called leaving group, like halide, triflate or tosylate that can undergo a nucleophilic substitution reaction with a tertiary amine group; and $R^7$ is a linear or branched hydrocarbon group with 1 to 8 carbon atoms.

Preferred compounds of general formula (II) are monochloroacetic acid, derivatives of lactic acid, such as tosylated lactic acid, monochloropropionic acid, and higher homologous carboxylic acids substituted with a leaving group.

One or more types of quaternization agents may be used, either simultaneously or subsequently.

The conversion of repeating units 2 via quaternization can be determined by the amine value of the polymer by DIN 16945.

Generally, the block co-polymer has an amine value in the range of 1 to 250 mg KOH/g. In preferred embodiments, the amine value of the block copolymer is in the range of 50 to 180 mg KOH/g, more preferred 100 to 140 mg KOH/g, or 110 to 130 mg KOH/g.

In one embodiment, the block co-polymer consists of or essentially consists of the first block and the second block, which have been described above. In a further embodiment, the block co-polymer comprises a third block, which

is different from the first block and the second block. The third block may be connected to the first block or the second block as a terminal block of the co-polymer. In a preferred embodiment, the third block is located between the first block and the second block. In this case, the third block may consist of a combination of the repeating units of the first block and the second block.

In typical embodiments of the block co-polymer, the weight ratio of the first block and the second block is in the range of 90:10 to 25:75. In preferred embodiments, the weight ratio of the first block and the second block is in the range of 80:20 to 50:50.

A preferred block co-polymer of the invention is a block co-polymer preferably having a number-average molecular weight $M_n$ of 2000 to 20000 g/mol, more preferably of 3000 to 17000 g/mol, even more preferably of 4000 to 12000 g/mol and most preferably of 4000 to 10000 g/mol. The number-average molecular weight $M_n$ and the weight-average molecular weight $M_w$ are determined in accordance with DIN 55672-1:2007-08 by means of gel permeation chromatography using tetrahydrofuran containing 1 % by volume of dibutylamine as eluent and polystyrene as standard. If the number-average molecular weight is too high, the viscosity may deteriorate.

The block co-polymer of the invention generally has a low polydispersity. Polydispersity is the weight average molecular weight $M_w$ divided by the number average molecular weight $M_n$. Preferably, the polydispersity of the block co-polymer is in the range of 1.03 to 1.80, more preferably 1.05 to 1.40.

The invention further relates to a composition comprising

(A) at least one wetting and/or dispersing agent, which is a block co-polymer as described above,
(B) at least one colorant, and
(C) at least one organic solvent.

The colorant (B) can be at least one pigment or at least one dye or a mixture of pigments or a mixture of at least one pigment and at least one dye, or a mixture of dyes. As the colorant in the inventive composition, a pigment is preferred. Organic and/or inorganic pigments can be used. Preferred are organic pigments. Colorants further include so-called dispersed dyes. In certain applications, a mixture of dyes is preferred for blue colors, a mixture of pigments is preferred for green colors, and a mixture of pigments or a mixture of pigment and dye is preferred for red colors.

Colors of a color filter are usually red, green or blue with a black matrix surrounding the pixels. Very often pigments are mixed to achieve the color of the certain pixel. For example, the green pixel composition can contain a blend of pigments with a green shade and a yellow shade.

Preferred organic pigments are azo-pigments, phthalocyanine-pigments, quinacridone-pigments, benzimidazolone-pigments, isoindolinone-pigments, dioxazine-pigments, indanthrene-pigments, and perylene-pigments. The pigments can also be inorganic pigments. Examples of usable pigments will be shown below by a pigment number. "C.I." listed below means color index.

Examples of red pigments used as colorant (B) include C.I. Pigment Red 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57, 57:1, 57:2, 58:4, 60, 63, 63:1, 63:2, 64, 64:1, 68, 69, 81, 81:1, 81:2, 81:3 ,81:4, 83, 88, 90:1, 101, 101:1, 104 ,108, 108:1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, and 276. Among the above, C.I. Pigment Red 48:1, 122, 168, 177, 202, 206, 207, 209, 224, 242 or 254 is preferable, and C.I. Pigment Red 177, 209, 224, or 254 is further preferable.

Examples of red dyes used as colorant (B) are C.I. Solvent Red 25, 27, 30, 35, 49, 83, 89, 100, 122, 138, 149, 150, 160, 179, 218, 230; C.I. Direct Red 20, 37, 39, 44; C.I. Acid Red 6, 8, 9, 13, 14, 18, 26, 27, 51, 52, 87, 88, 89, 92, 94, 97, 111, 114, 115, 134, 145, 151, 154, 180, 183, 184, 186, 198; C.I. Basic Red 12 and 13; C.I. Disperse Red 5, 7, 13, 17 and 58. The red dyes can be used in combination with yellow and/or orange dyes.

Examples of blue pigments used as colorant (B) include C.I. Pigment Blue 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, and 79. Among them, C.I. Pigment Blue 15, 15:1, 15:2, 15:3, 15:4 or 15:6 is preferable, and C.I. Pigment Blue 15:3, 15:4 or 15:6 are further preferable.

Examples for blue dyes used as colorant (B) are C.I. Solvent Blue 25, 49, 68, 78, 94; C.I. Direct Blue 25, 86, 90, 108; C.I. Acid Blue 1, 7, 9, 15, 103, 104, 158, 161; C.I. Basic Blue 1, 3, 9, 25 and C.I. Disperse Blue 198.

Examples of the green pigment used as colorant (B) include C.I. Pigment Green 1, 2, 4, 7, 8, 10, 13, 14, 15, 17, 18, 19, 26, 36, 45, 48, 50, 51, 54, 55, 58, 59, 60, 61, or 62. Among them, C.I. Pigment Green 7, 36, 58, 59, 62 and 63 is preferable.

Examples of green dyes used as colorant (B) are C.I. Acid Green 3, 9, 16 and C.I. Basic Green 1 and 4.

Examples of the yellow pigment used as colorant (B) include C.I. Pigment Yellow 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75,

81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, 208 or 213. Among them, C.I. Pigment Yellow 83, 117, 129, 138, 139, 150, 154, 155, 180, or 185 is preferable, and C.I. Pigment Yellow 83, 138, 139, 150, 180, 185 or 213 is further preferable.

Examples for yellow dyes used as colorant (B) are C.I. Solvent Yellow 2, 5, 14, 15, 16, 19, 21, 33, 56, 62, 77, 83, 93, 104, 105, 114, 129, 130, 162; C.I. Disperse Yellow 3, 4, 7, 31, 54, 61, 201; C.I. Direct Yellow 1, 11, 12, 28; C.I. Acid Yellow 1, 3, 11, 17, 23, 38, 40, 42, 76, 98; C.I. Basic Yellow 1.

Examples of a violet pigment used as colorant (B) include C.I. Pigment Violet 1, 1:1, 2, 2:2, 3, 3:1, 3:3, 5, 5:1, 14, 15, 16, 19, 23, 25, 27, 29, 31, 32, 37, 39, 42, 44, 47, 49, and 50. Among them, C. I. Pigment Violet 19, or 23 is preferable, and C. I. Pigment Violet 23 is further preferable.

Examples of violet dyes used as colorant (B) are C.I. Solvent Violet 13, 33, 45, 46; C.I. Disperse Violet 22, 24, 26, 28, C.I. Acid Violet 49, and C.I. Basic Violet 2, 7, 10.

Examples of an orange pigment used as colorant (B) include C.I. Pigment Orange 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, and 79. Among them, C.I. Pigment Orange 36, 38 and 71 are preferable.

Examples of orange dyes used as colorant (B) are C.I. Solvent Orange 1, 2, 5, 6, 37, 45, 62, 99; C.I. Acid Orange 1, 7, 8, 10, 20, 24, 28, 33, 56, 74; C.I. Direct Orange 1 and C.I. Disperse Orange 5.

Besides so-called "single grinds" of dispersions of one type of pigment, another example for the highly beneficial use of the inventive di-block co-polymer as wetting agent and/or dispersant is the dispersing and stabilization of mixtures of organic pigments, so-called "co-grinds". Mixtures of organic pigments are produced to obtain colored coatings, especially photoresists, with unique coloristic properties matching best the color space that the human eye can interpret. Mixtures of organic pigments and their co-grinds in the sense of this invention can comprise, for instance: C.I. Pigment Blue 15:6 and C.I. Pigment Violett 23; C.I. Pigment Blue 15:4 and C.I. Pigment Violett 23; C.I. Pigment Blue 15:3 and C.I. Pigment Violett 23; C.I. Pigment Green 58 and C.I. Pigment Yellow 138; C.I. Pigment Green 58 and C.I. Pigment Yellow 213; C.I. Pigment Green 59 and C.I. Pigment Yellow 138; C.I. Pigment Green 36 and C.I. Pigment Yellow 138; C.I. Pigment Green 7 and C.I. Pigment Yellow 138 among others.

It is preferable that the pigment(s) used as colorant (B) have an average median particle diameter of 1 μm or less, preferably 0.3 μm or less, further preferably 50 nm or less determined by laser diffraction according ISO 13320:2009.

A black pigment may be used alone, or may be used by mixing with the red, green or blue pigment(s) as colorant (B). Examples of the black pigment which can be used alone include carbon black, acetylene black, lamp black, bone black, graphite, iron black, titanium black , perylene black and other organic pigment. Among them, from a viewpoint of a light shielding rate and image property, carbon black and titanium black are preferable.

Examples of carbon black include MA7, MA8, MA11, MA100, MA100R, MA220, MA230, MA600, #5, #10, #20, #25, #30, #32, #33, #40, #44, #45, #47, #50, #52, #55, #650, #750, #850, #950, #960, #970, #980, #990, #1000, #2200, #2300, #2350, #2400, #2600, #3050, #3150, #3250, #3600, #3750, #3950, #4000, #4010, OIL7B, OIL9B, OIL11B, OIL30B, OIL31B as manufactured by Mitsubishi Chemical Corporation; Printex3, Printex30P, Printex30, Printex30OP, Printex40, Printex45, Printex55, Printex60, Printex75, Printex80, Printex85, Printex90, Printex A, Printex ex L, Printex G, Printex P, Printex U, Printex V, Printex G, Special Black 550, Special Black 350, Special Black 250, Special Black 100, Special Black 6, Special Black 5, Special Black 4, Color Black FW1, Color Black FW2, Color Black FW2V, Color Black FW18, Color Black FW18, Color Black FW200, Color Black S160, Color Black S170 as manufactured by Degussa; Monarch 120, Monarch 280, Monarch 460, Monarch 800, Monarch 880, Monarch 900, Monarch 1000, Monarch 1100, Monarch 1300, Monarch 1400, Monarch 4630, REGAL99, REGAL99R, REGAL415, REGAL415R, REGAL250, REGAL250R, REGAL330, REGAL400R, REGAL55R0, REGAL660R, BLACK PEARLS480, PEARLS130, VULCAN XC72R, ELFTEX-8 as manufactured by Cabot; RAVEN11, RAVEN14, RAVEN15, RAVEN16, RAVEN22, RAVEN30, RAVEN35, RAVEN40, RAVEN410, RAVEN420, RAVEN450, RAVEN500, RAVEN780, RAVEN850, RAVEN890H, RAVEN1000, RAVEN1020, RAVEN1040, RAVEN1060U, RAVEN1080U, RAVEN1170, RAVEN1190U, RAVEN1250, RAVEN1500, RAVEN2000, RAVEN2500U, RAVEN3500, RAVEN5000, RAVEN5250, RAVEN5750, RAVEN7000 as manufactured by Columbia Carbon.

Examples of perylene black include C.I. Black pigment 31 and 32. Example of other organic black pigment is Black S 0100 CF as manufactured by BASF.

The median primary particle diameter determined by laser diffraction according to ISO 13320:2009 is preferably 0.01 to 0.08 μm and the "nitrogen absorption specific surface area" is preferably 50 to 120 $m^2/g$ for the black pigments determined via ISO 9277:2010.

For the black matrix instead of carbon black, pigment mixtures of three colors of red, green and blue can be used. Examples of a coloring material which can be mixed for preparing the black pigment include C.I. Yellow Pigment 20, 24, 86, 93, 109, 110, 117, 125, 137, 138, 147, 148, 153, 154, 166; C.I. Orange Pigment 36, 43, 51, 55, 59, 61; C.I. Red Pigment 9, 97, 122, 123, 149, 168, 177, 180, 192, 215, 216, 217, 220, 223, 224, 226, 227, 228, 240; C.I. Violet

Pigment 19, 23, 29, 30, 37, 40, 50; C.I. Blue Pigment 15, 15:1, 15:4,15:6, 22, 60, 64; C.I. Green Pigment 6, 36, 58, 59; C.I. Brown Pigment 23, 25 and 26, respectively.

The relative weight ratio of dispersants and/or wetting agents (A) to colorants (B) in the compositions of the present invention is preferably 95:5 to 5:95, more preferably 65:35 to 7:93 and in particular preferably 50:50 to 10:90.

The organic solvent (C) preferably has a boiling point at standard pressure (101.325 kPa) in a range of 100 to 300°C, more preferable a boiling point in the range of 120 to 250°C.

The content of the organic solvent (C) of the inventive composition is preferably 10 to 99% by weight, more preferably 20 to 97 % by weight of the total weight of the inventive composition.

Examples of such an organic solvent include glycol monoalkyl ethers such as ethylene glycolmonobutyl ether, propylene glycol monomethyl ether; glycol dialkyl ethers such as ethylene glycol diethyl ether, diethylene glycol dimethyl ether, diethylene glycol diethyl ether; glycol alkyl ether acetates such as ethylene glycol monomethyl ether acetate, ethylene glycol monoethyl ether acetate, propylene glycol monomethyl ether acetate, propylene glycol monoethyl ether acetate, propylene glycol monopropyl ether acetate, methoxybutyl acetate; dialkyl ethers such as diethyl ether; ketones such as acetone, methyl ethyl ketone, cyclohexanone; monohydric or polyhydric alcohols such as ethanol, propanol, butanol, hexanol, cyclohexanol, ethylene glycol, propylene glycol, diethylene glycol, dipropylene glycol, and glycerin; aliphatic hydrocarbons such as n-hexane; alicyclic hydrocarbons such as cyclohexane; aromatic hydrocarbons such as toluene, xylene, and cumene; linear or cyclic esters such as ethyl acetate, butyl acetate; nitriles such as acetonitrile, and benzonitrile or mixtures thereof. Also suitable are ethoxy ethyl propionate, and solvent blends containing n-butanol, for example blends of n-butanol and dimethyl sulfoxide.

Preferably, organic solvent (C) is selected from the group consisting of glycol monoalkyl ethers, glycol dialkyl ethers, glycol alkyl ether acetates and mixtures thereof. Glycol alkyl ether acetates are even more preferred. Most preferred is propylene glycol monomethyl ether acetate. Glycol alkyl ether acetates may be used alone or in combination with other solvents.

The organic solvent is usually used to adjust the solids content and viscosity of the compositions according to the present invention and is only limited by the amount of the other ingredients.

Preferably, the composition of the invention further contains at least one polymeric resin (D), which is an alkali-soluble resin.

Examples of suitable alkali-soluble resins include the known polymers described and mentioned in JP-A No. H07-207211, JP-A No. H08-259876, JP-A No. H10-300922, JP-A No. H11-140144, JP-A No. H11-174224, JP-A No. 2000-56118, JP-A No. 2003-233179, JP-A No. H08-297366, JP-A No. 2001-89533, JP-A No. 2003-89716, JP-A No. 2003-165830, JP-A No. 2005-325331, and JP-A No. 2001-354735; resins described in JP-A No. 2005-126674, JP-A No. 2005-55814, and JP-A No. 2004-295084, JP-A No. 2005-154708, JP-A 2009-025813 and US 8 216 770.

Preferred alkali-soluble resins are:

(a) Co-polymers of ethylenically unsaturated monomers with (meth)acrylic acid and/or maleic anhydride, wherein preferred ethylenically unsaturated co-monomers are selected from the group consisting of styrene, benzyl methacrylate, 2-hydroxyethyl (meth)acrylate, methyl methacrylate, cyclohexyl methacrylate, isobornyl methacrylate, adamantly (meth)acrylate and glycidyl methacrylate. In case a glycidyl group is incorporated in the polymer a post reaction with acids or acid anhydrides to incorporate functional groups like carboxylic acid or (meth)acrylate moieties can be performed.

(b) Reaction products of ethylenically unsaturated monocarboxylic acid or its ester with an epoxy resin and a carboxylic acid anhydride, wherein examples of epoxy resins are monomeric and oligomeric bisphenol A, F, S-type epoxy resins, novolak-type epoxy resin, trigylcidyl isocyanurate, fluorene epoxy resin, so called cardo resin, and wherein examples of acid anhydrides are maleic anhydride, succinic anhydride, itaconic anhydride, phthalic anhydride, tetrahydrophthalic anhydride, hexahydrophthalic anhydride, pyromellitic anhydride and trimellitic anhydride.

Each of these alkali-soluble resins can be used alone or in combination. In some embodiments, the alkali-soluble resin has an acid value in the range of 80 to 100 mg KOH/g. Alkali-soluble resins having number average molecular weight in the range of 400 to 8000 g/mol are often used.

In the composition of the present invention, the amount of the alkali-soluble resin (D) to be contained is preferably, 0.1 to 80 % by weight, preferably 1 to 60 % by weight, based on the total non-volatile matter of the composition. The amount of non-volatile matter is determined via DIN EN ISO 3251:2008-06 at 150 °C for 20 min.

Preferably, the inventive composition further comprises ethylenically unsaturated component (E) having at least one ethylenically unsaturated polymerizable group.

The ethylenically unsaturated component is not particularly limited as far as it is a polymerizable low-molecular weight compound containing at least one ethylenically unsaturated functional group. Preferably, it comprises at least one further functional group which can also be an ethylenically unsaturated functional group or a group selected from

hydroxyl groups and carboxyl groups.

The ethylenically unsaturated component includes dimers, trimers, and low molecular weight oligomers in addition to a monomer in a narrow sense. Preferably, component (E) has a number-average molecular weight of less than 1000 g/mol. The number-average molecular weight is determined according to the method described in the experimental part.

In a preferred embodiment of the present invention, the ethylenically unsaturated component contains two or more ethylenically unsaturated groups, even more preferred 2 to 6 ethylenically unsaturated groups.

Examples of the ethylenically unsaturated component include unsaturated carboxylic acids such as (meth)acrylic acid, esters of aliphatic polyhydroxy compounds and unsaturated carboxylic acids, esters of aromatic polyhydroxy compounds and unsaturated carboxylic acids, esters obtained by an esterification reaction of unsaturated carboxylic acids or polyvalent carboxylic acids and polyhydric hydroxy compounds such as the above aliphatic polyhydroxy compounds and the aromatic polyhydroxy compounds, and ethylenically unsaturated compounds having a urethane skeleton, so-called urethane(meth)acrylates, which are preferably obtainable by reacting a polyisocyanate compound and a (meth)acryloyl group-containing hydroxy compound.

Preferred are esters of aliphatic polyhydroxy compounds and unsaturated carboxylic acids including (meth)acrylic acid esters such as ethylene glycol di(meth)acrylate, triethylene glycol di(meth)acrylate, trimethylolpropane tri(meth)acrylate, trimethylolethane tri(meth)acrylate, pentaerythritol di(meth)acrylate, pentaerythritol tri(meth)acrylate, pentaerythritol tetra(meth)acrylate, dipentaerythritol tetra(meth)acrylate, dipentaerythritol penta(meth)acrylate, dipentaerythritol hexa(meth)acrylate, and glycerol (meth)acrylate.

The ethylenically unsaturated component (E) may also contain carboxylic acid groups. In such case the acid value of the ethylenically unsaturated component is preferably 5 to 30 mg KOH/g.

Different ethylenically unsaturated compounds (E) may be used also in combination. A preferred combination of multifunctional ethylenically unsaturated monomers having an acid value is a mixture containing, as a main component, dipentaerythritol hexaacrylate, dipentaerythritol pentaacrylate and succinic acid ester of dipentaerythritol pentaacrylate, which is commercially available as "TO1382" manufactured by Toagosei Co. Ltd. This mixture of multifunctional ethylenically unsaturated monomers may be used by combining with other multifunctional monomers.

In the composition of the present invention, the amount of ethylenically unsaturated component (E) is preferably 0.1 to 80 % by weight, more preferably 5 to 70 % by weight, further preferably 10 to 50 % by weight and particularly preferably 10 to 40% by weight, based on the total non-volatile matter. The amount of non-volatile matter is determined via DIN EN ISO 3251:2008-06 at 150 °C for 20 min.

The composition may also contain at least one further component (F) which differs from the components (A), (B), (C), (D) and (E). Such a further component (F) is preferably selected from the group consisting of photopolymerization initiating agents, polymerization accelerators, sensitizing dyes different from (B), surfactants and further wetting and/or dispersing additives different from (A), monofunctional ethylenically unsaturated monomers differing from (E), as e.g. esters of monohydroxy compounds and unsaturated carboxylic acids such as esters of a saturated monoalkohol and (meth)acrylic acid, and mixtures thereof.

A photopolymerization initiator (F) is usually used as a mixture of a photopolymerization initiating agent, and a polymerization accelerator which is added, if necessary, and is a component which absorbs light directly or is photosensitized to cause a degradation reaction or a hydrogen extraction reaction, and has the function of generating a polymerization active radical. Different kinds of photopolymerization initiating agents are well known in the literature and the inventive composition is not limited in terms of use of the different kinds of photopolymerization initiating agents in combination with the inventive composition. Examples of the photopolymerization initiator (F) include titanocene derivatives described in JP-A No. 59-152396, and JP-A No. 61-151197; hexaarylbiimidazole derivatives described in JP-A No. 10-300922, JP-A No. 11-174224, and JP-A No. 2000-56118; radical activating agents such as halomethylated oxadiazole derivatives, halomethyl-s-triazine derivatives, N-aryl-$\alpha$-amino acids such as N-phenylglycine, N-aryl-$\alpha$-amino acid salts, and N-aryl-$\alpha$-amino acid esters, and $\alpha$-aminoalkylphenone derivatives described in JP-A No. 10-39503; oxime ester-based derivatives described in JP-A No. 2000-80068. There is a trend towards using photopolymerization initiators which are active at higher wavelength, for example in the range of 365 to 405 nm.

Examples of the polymerization accelerator (F) which is used, if necessary, include N,N-dialkylaminobenzoic acid alkyl esters such as N,N-dimethylaminobenzoic acid ethyl ester; mercapto compounds such as mercapto compounds having a heterocycle such as 2-mercaptobenzothiazole, 2-mercaptobenzoxazole and 2-mercaptobenzoimidazole; or aliphatic multifunctional mercapto compounds.

The photopolymerization initiating agents (F) and polymerization accelerators (F) may be used alone or in combination.

For the purpose of enhancing sensitivity, one or more sensitizing dyes (F) differing from colorants (B) may be used in the composition of the present invention. As the sensitizing dye, a suitable sensitizing dye depending on the wavelength of an exposure light source is used, and examples include xanthene-based dyes described in JP-A No. 4-221958, and JP-A No. 4-219756; coumarin-based dyes having a heterocycle described in JP-A No. 3-239703, and

JP-A No. 5-289335; 3-ketocoumarin-based dyes described in JP-A No. 3-239703, and JP-A No. 5-289335; pyrromethene-based dyes described in JP-A No. 6-19240; dyes having a dialkylaminobenzene skeleton described in JP-A Nos. 47-2528 and 54-155292, JP-B No. 45-37377, JP-A Nos. 48-84183, 52-112681, 58-15503, 60-88005, 59-56403, 2-69, 57-168088, 5-107761, 5-210240 and 4-288818.

The composition of the present invention may further contain one or more surfactants (F). As the surfactant, various surfactants such as anionic, cationic, nonionic, and amphoteric surfactants can be used. It is preferable to use nonionic surfactants from the viewpoint that it is unlikely that various properties such as voltage retainability and compatibility with organic solvent are impaired. Examples of anionic surfactants include alkyl sulfuric acid ester salt-based surfactants such as "Emal 10" manufactured by Kao Corporation, alkylnaphthalenesulfonic acid salt-based surfactants such as "Pelex NB-L" manufactured by Kao Corporation, and special polymer-based surfactants such as "Homogenol L-18" and "Homogenol L-100" manufactured by Kao Corporation. Among them, special polymer-based surfactants are preferable, and special polycarbonic acid-type polymer-based surfactants are more preferable. Examples of cationic surfactants include alkylamine salt-based surfactants such as "Acetamine 24" manufactured by Kao Corporation, and quaternary ammonium salt-based surfactants such as "Cotamine 24P" and "Cotamine 86W" manufactured by Kao Corporation. Among them, quaternary ammonium salt-based surfactants are preferable, and stearyltrimethylammonium salt-based surfactants are more preferable. Examples of nonionic surfactants include "SH8400" manufactured by Dow Corning Toray; silicone-based surfactants such as "KP341" manufactured by Shin-Etsu Silicone; "FC430" manufactured by Sumitomo 3M; "F470" manufactured by DIC Corporation; fluorine-based surfactants such as "DFX-18" manufactured by Neos; polyoxyethylene-based surfactants such as "Emulgen 104P" and "Emulgen A60" manufactured by Kao Corporation. Among them, silicone-based surfactants are preferable, and so-called polyether-modified or aralkyl-modified silicone-based surfactants having a structure in which a side chain of a polyether group or aralkyl group is added to polydimethylsiloxane are more preferable. Two or more kinds of surfactants may be used together, and examples include a combination of silicone-based surfactants/fluorine-based surfactants, silicone-based surfactants/special polymer-based surfactants, or fluorine-based surfactants/special polymer-based surfactants. Inter alia, a combination of silicone-based surfactants/fluorine-based surfactants is preferable. Examples of this combination of silicone-based surfactants/fluorine-based surfactants include a combination of polyether-modified silicone-based surfactants/oligomer-type fluorine-based surfactants. Specifically, examples include a combination of "TSF4460" manufactured by GE Toshiba Silicone/"DFX-18" manufactured by Neos, "BYK-300" manufactured by BYK/"S-393" manufactured by Seimi Chemical, "KP340" manufactured by Shin-Etsu Silicone/"F-478" and F 470 manufactured by DIC Corporation, "SH7PA" manufactured by Dow Corning Toray/"DS-401" manufactured by Daikin, or "L-77" manufactured by Nippon Unicar/"FC4430" manufactured by Sumitomo 3M.

The composition of the present invention may contain further wetting and/or dispersing additives, which differ from dispersant (A) and are used additionally to dispersant (A) in such a range that the effect of the present invention is not impaired. The kind of further dispersant is not particularly limited as far as the effect of the present invention is not impaired.

The composition of the present invention may contain esters of monohydroxy compounds and unsaturated carboxylic acids, as e.g. esters of (meth)acrylic acid with a saturated monoalcohol. Such monomers, which differ from monomers (E) are preferably used in mixture with monomers (E).

The invention further relates to a process for preparing a color filter, wherein the process comprises the steps of applying the composition of the invention to a substrate and curing selected areas of the composition by exposure to actinic radiation. Actinic radiation is radiation capable of triggering chemical reactions. Examples of actinic radiation are UV radiation and electron beam radiation. In a preferred embodiment, the process further comprises the step of treating the color filter with an alkali-containing solution and removing uncured material.

Preferably, the color filter is included in a liquid crystal display, a liquid crystal screen, a color resolution device or a sensor.

## Examples

Raw materials:

| | |
|---|---|
| MMA: | methyl methacrylate (manufacturer: Evonik) |
| BMA: | n-butyl methacrylate (manufacturer: Evonik) |
| CHMA: | cyclohexyl methacrylate (manufacturer: Evonik) |
| BzMA: | benzyl methacrylate (manufacturer: Evonik) |
| EHMA: | 2-ethylhexyl methacrylate (manufacturer: Evonik) |
| iBOMA: | iso bornyl methacrylate (manufacturer: Evonik) |
| MTGMA: | methyltriglycol methacrylate (purchased from Sigma-Aldrich) |
| BDGMA: | butyldiglycol methacrylate (purchased from Sigma-Aldrich) |

| | |
|---|---|
| ETGMA: | ethyltriglycol methacrylate (manufacturer: Evonik) |
| DMAEMA: | N,N-dimethylaminoethyl methacrylate (manufacturer: Evonik) |
| Initiator: | 1-methoxy-1-(trimethylsiloxy)-2-methylpropene (purchased from Sigma-Aldrich) |
| Catalyst: | tetrabutylammonium 3-chlorobenzoate, 50% strength in acetonitrile, see US 4,588,795 |
| AMBN: | 2,2'-azo-di(2-methylbutyronitrile) (manufacturer: Akzo Nobel) |
| PMA: | 1-methoxy-2-propyl acetate (manufacturer: DOW Chemical) |
| PM: | 2-methoxypropanol (manufacturer: DOW Chemical) |

1-Methoxy-2-propyl acetate and all monomers are stored over 3 Å molecular sieve for 48 hours before use.

Gel Permeation Chromatography (GPC)

Number-average $M_n$ and weight-average $M_w$ molecular weights and the molecular weight distribution were determined according to DIN 55672-1:2007-08 at 40 °C using a high-pressure liquid chromatography pump (WATERS 600 HPLC pump) and a refractive index detector (Waters 410). As separating columns, a combination was used of 3 Styragel columns from WATERS with a size of 300 mm x 7.8 mm ID/column, a particle size of 5 $\mu$m, and pore sizes HR4, HR2 and HR1. The eluent used was tetrahydrofuran with 1% by volume of dibutylamine, with an elution rate of 1 mL/min. The conventional calibration was carried out using polystyrene standards.

Measurement of non-volatile content (solids content)

The sample (2.0 $\pm$ 0.2 g of the tested substance) was weighed accurately into a previously dried aluminum dish and dried for 20 minutes at 150 °C in the varnish drying cabinet, cooled in a desiccator and then reweighed. The residue corresponds to the solids content in the sample (ISO 3251).

Measurement of the amine value

0.5 to 1.5 g of a dispersant was precisely weighed out into a 100 mL beaker and is dissolved with 50 mL of acetic acid. Using an automatic titration device provided with a pH electrode, this solution was neutralization-titrated with a 0.1 mol/L $HClO_4$ acetic acid solution. A flexion point of a titration pH curve was used as a titration endpoint, and an amine value was obtained by the following equation.

$$\text{Amine value [mg KOH/g]} = (561 \times V) / (W \times S)$$

(wherein W: weighed amount of dispersant sample [g], V: titration amount at titration endpoint [mL], S: solid matter concentration of dispersant sample [wt.-%])

General procedure for preparing block co-polymers 1-9 (see Table 1)

75 g of 1-methoxy-2-propyl acetate were placed into a water-free reaction vessel. Monomer mixture 1 was metered at a rate of 1.2 g/min. Immediately after the start of the metering, the respective amount of initiator and 10 wt.-% of the catalyst, in respect to the amount of initiator, were introduced into the reaction vessel. Throughout the reaction, the reaction temperature was kept at 20 °C. After the end of the metering of monomer mixture 1, monomer 2 was metered in at a rate of 1.3 g/min. The subsequent reaction time after the end of the metering of monomer 2 was 60 minutes. Afterwards 3.3 g of 2-methoxypropanol were added in order to stop the reaction.

Procedure for preparing block co-polymer 10 by (see Table 1)

75 g of 1-methoxy-2-propyl acetate were placed into a water-free reaction vessel. 59.1 g of monomer mixture 1 was metered in at a rate of 1.2 g/min. Immediately after the start of the metering, the respective amount of initiator and 10 wt.-% of the catalyst, in respect to the amount of initiator, were introduced into the reaction vessel. Throughout the reaction, the temperature was kept at 20 °C. After finalization of the dosage of 59.1 g of monomer mixture 1 additional 19.3 g of monomer mixture 1 was metered in within 14 minutes with a continuously reduced metering rate of 1.2 g/min to 0.5 g/min. Parallel 16.2 g of monomer 2 were metered in with a continuously increased metering rate of 0.5 g/min to 1.3 g/min. The residual amount of monomer 2 was metered in at a rate of 1.3 g/min after finalization of the parallel metering of monomer mixture 1 and monomer 2. The subsequent reaction time after the end of the metering of monomer 2 was 60 minutes. Afterwards 3.3 g of 2-methoxypropanol were added in order to stop the reaction.

Procedure for preparing block co-polymer 11 (see Table 1)

75 g of 1-methoxy-2-propyl acetate were placed into a water-free reaction vessel. 70.9 g of monomer mixture 1 was metered in at a rate of 1.2 g/min. Immediately after the start of the metering, the respective amount of initiator and 10 wt.-% of the catalyst, in respect to the amount of initiator, were introduced into the reaction vessel. Throughout the reaction, the temperature was kept at 20 °C. After finalization of the dosage of 70.9 g of monomer mixture 1 additional 7.5 g of monomer mixture 1 was metered in at a rate of 0.6 g/min parallel to 16.2 g of monomer 2 which was metered in at a rate of 1.3 g/min. The residual amount of monomer 2 was metered in at a rate of 1.3 g/min after finalization of the parallel metering of monomer mixture 1 and monomer 2. The subsequent reaction time after the end of the metering of the monomer 2 was 60 minutes. Afterwards 3.3 g of 2-methoxypropanol were added in order to stop the reaction.

Procedure for preparing block co-polymer 12 (see Table 1)

75 g of 1-methoxy-2-propyl acetate were placed into a water-free reaction vessel. 59.1 g of monomer mixture 1 was metered in at a rate of 1.2 g/min. Immediately after the start of the metering, the respective amount of initiator and 10% wt.-% of the catalyst, in respect to the amount of initiator, were introduced into the reaction vessel. Throughout the reaction, the temperature was kept at 20 °C. A combination of 19.3 g of monomer mixture 1 and 16.2 g of monomer 2 was metered in at a rate of 1.2 g/min. After the end of the metering, 23.6 g of monomer 2 was metered in at a rate of 1.3 g/min. The subsequent reaction time after the end of the metering of monomer 2 was 60 minutes. Afterwards 3.3 g of 2-methoxypropanol were added in order to stop the reaction.

Table 1: Raw material quantities in gram for preparing block co-polymers 1 to 12 and analytical data thereof

| Poly-mers | Initiator / Catalyst | Monomer Mixture 1 | | | | | | | | | Monomer 2 | Amine Value of Polymers | $M_n$ | $M_w$ / $M_n$ | Solids content in % |
|---|---|---|---|---|---|---|---|---|---|---|---|---|---|---|---|
| | | MMA | BMA | EHMA | CHMA | BzMA | iBOMA | MTGMA | ETGMA | BDGMA | DMAEMA | | | | |
| 1* | 3.3/0.33 | | 39.2 | | | 31.3 | | | 7.8 | | 39.8 | 118 | 7191 | 1.21 | 60 |
| 2* | 3.3/0.33 | | 31.3 | | 19.6 | | 19.6 | | | 7.8 | 39.8 | 118 | 7404 | 1.26 | 60 |
| 3* | 3.3/0.33 | 23.5 | 15.7 | 15.7 | | 15.7 | | | 7.8 | | 39.8 | 118 | 7654 | 1.25 | 60 |
| 4* | 3.3/0.33 | 15.7 | 3.9 | | 15.7 | | 15.7 | | 27.4 | | 39.8 | 118 | 7320 | 1.24 | 60 |
| 5 | 3.3/0.33 | 31.3 | 15.7 | 15.7 | | 7.8 | | 3.9 | | 3.9 | 39.8 | 118 | 7126 | 1.19 | 60 |
| 6 | 3.3/0.33 | 31.3 | 15.7 | 15.7 | | 7.8 | | 2.4 | | 5.5 | 39.8 | 118 | 7022 | 1.27 | 60 |
| 7 | 3.3/0.33 | 31.3 | 15.7 | 15.7 | | 7.8 | | 5.5 | | 2.4 | 39.8 | 118 | 7464 | 1.19 | 60 |
| 8 | 3.3/0.33 | 28.9 | 14.5 | 14.5 | | 7.2 | | 3.9 | 5.5 | 3.9 | 39.8 | 118 | 7477 | 1.26 | 60 |
| 9 | 3.3/0.33 | 28.7 | 14.4 | 14.4 | 2.8 | 7.2 | 3.5 | 3.7 | | 3.7 | 39.8 | 118 | 7117 | 1.23 | 60 |
| 10 | 3.3/0.33 | 31.3 | 15.7 | 15.7 | | 7.8 | | 3.9 | | 3.9 | 39.8 | 118 | 7588 | 1.19 | 60 |
| 11 | 3.3/0.33 | 31.3 | 15.7 | 15.7 | | 7.8 | | 3.9 | | 3.9 | 39.8 | 118 | 7530 | 1.27 | 60 |
| 12 | 3.3/0.33 | 31.3 | 15.7 | 15.7 | | 7.8 | | 3.9 | | 3.9 | 39.8 | 118 | 7045 | 1.17 | 60 |

Comparative examples are marked with *

Preparation of alkali-soluble resin R1:

300 g of 1-methoxy-2-propyl acetate were placed into a reaction vessel. 137 g of BzMA, 34 g of methacrylic acid and 1.65 g of AMBN were metered in at a temperature of 120 °C over 180 minutes. The subsequent reaction time after the end of the metering was 120 minutes. The solids content was then adjusted to 35 wt.-% with 1-methoxy-2-propyl acetate (DIN EN ISO 3251:2008-06 at 150 °C for 20 min).

Preparation of the pigment dispersions

Pigments:

| | |
|---|---|
| PG 58 | Fastogen Green A110 (manufacturer: DIC) |
| PY 150 | Chromophtal Yellow D1085J (manufacturer: BASF) |

PG 58/PY 150 pigment dispersion

| | |
|---|---|
| Alkali-soluble resin R1 | 7.14 g |
| 1-Methoxy-2-propyl acetate | 29.11 g |
| n-Butanol | 2.50 g |
| Block Co-polymer | 3.75 g |
| PG 58 | 4.30 g |
| PY 150 | 3.20 g |

The alkali-soluble resin R1, 1-methoxy-2-propyl acetate, n-butanol, the block co-polymer as per table 1, 4.3 g Pigment Green 58, and 3.20 g Pigment Yellow 150 were put together in a 100 mL glass bottle. 100 g of zirconium beads (diameter 0.4 - 0.6 mm) were added. Dispersion process was performed in a LAU-Disperser DAS 200 over a period of 5 hours at 40 °C. After 16 hours, the concentrate was filtered into a 50 mL glass bottle to remove the zirconium beads. The pigment dispersions also represent examples of the compositions according to the invention.

Measurement of the viscosity of the dispersions:

The pigment dispersions' viscosity was measured after grinding and filtering by means of an Anton-Paar Rheometer using the CP50-1 measurement system at 25 °C according to DIN 53019-1:2008-09. After one week, storage at 40 °C the viscosity was measured again.
Viscosity 1: the viscosity after grinding and filtering
Viscosity 2: the viscosity after storage for 7 days at 40 °C

Table 2: Results of the viscosity measurements:

| W&D additive | Viscosity 1 [mPa*s] | Viscosity 2 [mPa*s] |
|---|---|---|
| 1* | 120 | thick |
| 2* | thick | 29.8 |
| 3* | 118 | 30.1 |
| 4* | 230 | 22.6 |
| 5 | 43.1 | 11.2 |
| 6 | 43.5 | 11.0 |
| 7 | 35.5 | 11.1 |
| 8 | 28.6 | 10.0 |
| 9 | 28.7 | 10.3 |
| 10 | 18.3 | 11.2 |
| 11 | 30.2 | 13.9 |

(continued)

| W&D additive | Viscosity 1 [mPa*s] | Viscosity 2 [mPa*s] |
|---|---|---|
| 12 | 44.7 | 12.4 |
| Comparative examples are marked with * | | |

In Table 2, the indication "thick" means that the composition had almost solidified and that viscosity was too high to be measured. From Table 2 it can be inferred that the compositions containing the polymers according to the invention as dispersing agents have a significantly lower viscosity than the comparative compositions. The viscosity of the compositions of the invention is also more stable after storage at 40 °C than the comparative compositions.

## Claims

**1.** A block co-polymer comprising at least one first block and at least one second block which is different from the first block, wherein the first block comprises repeating units 1,

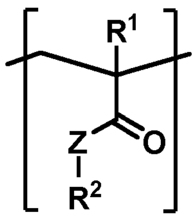
repeating unit 1

and the second block comprises repeating units 2,

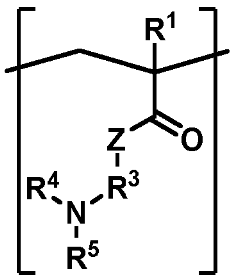
repeating unit 2

wherein

Z represents O or NH,
$R^1$ represents H or $CH_3$,
$R^2$ represents a group selected from hydrocarbyl groups and ether group-containing groups,
$R^3$ represents an organic group having 2 to 4 carbon atoms,
$R^4$ and $R^5$ independently represent an organic group, wherein $R^4$ and $R^5$ are optionally linked to each other to form a cyclic structure,
and wherein the first block comprises at least two different types of repeating units comprising ether groups.

**2.** The block co-polymer according to claim 1, wherein the second block further comprises repeating units 3

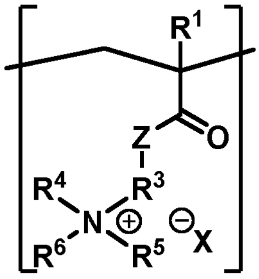
repeating unit 3

wherein $R^6$ represents an organic group and $X^-$ represents an anion.

3. The block co-polymer according to claim 1 or 2, wherein the first block comprises at least six different types of repeating units 1.

4. The block co-polymer according to any one of the preceding claims, wherein the first block comprises between 3 and 50 mol-% of repeating units comprising ether groups.

5. The block co-polymer according to any one of the preceding claims, wherein the first block consists of polymerized units of a) methyl methacrylate in an amount of 20 to 60 % by weight, b) butyl methacrylate in an amount of 10 to 30 % by weight, c) 2-ethylhexyl methacrylate in an amount of 10 to 30 % by weight, d) one or more methacrylates having an aromatic or aliphatic ring in an amount of 3 to 20 % by weight, and e) two or more methacrylates having ether groups in an amount of 3 to 20 % by weight, wherein the % by weight of a) to e) add up to 100 %.

6. The block co-polymer according to any one of the preceding claims, wherein the block co-polymer has a polydispersity in the range of 1.03 to 1.80.

7. The block co-polymer according to any one of the preceding claims, wherein the block co-polymer has a number average molecular weight $M_n$ in the range of 2000 to 20000 g/mol.

8. The block co-polymer according to any one of the preceding claims, wherein the first block comprises repeating units derived from monomers selected from ethyl triglycol methacrylate, methyl triglycol methacrylate, butyl diglycol methacrylate, and mixtures thereof.

9. The block co-polymer according to any one of the preceding claims, wherein the weight ratio of the first block and the second block is in the range of 90:10 to 25:75.

10. The block co-polymer according to any one of the preceding claims, wherein the block co-polymer comprises a third block, which is different from the first and the second block.

11. The block co-polymer according to claim 10, wherein the third block is located between the first block and the second block.

12. The block co-polymer according to any one of preceding claims 1 to 9, wherein the block co-polymer consists of the first block and the second block.

13. A composition comprising

(A) at least one wetting and/or dispersing agent,
(B) at least one colorant, and
(C) at least one organic solvent,
wherein the wetting and/or dispersing agent is a block co-polymer according to any one of the preceding claims.

14. The composition according to claim 13, wherein the colorant is selected from pigments, dyes, and mixtures thereof.

15. The composition according to claim 13 or 14, wherein the composition further comprises at least one alkali-soluble resin.

**16.** The composition according to any one of the preceding claims 13 to 15, wherein the composition further comprises a component having at least one ethylenically unsaturated polymerizable group.

**17.** A process for preparing a color filter, wherein the process comprises the steps of applying the composition according to any one of claims 13 to 16 to a substrate and curing selected areas of the composition by exposure to actinic radiation.

**18.** The process according to claim 17, wherein the color filter is included in a liquid crystal display, a liquid crystal screen, a color resolution device or a sensor.

**Patentansprüche**

**1.** Blockcopolymer, umfassend mindestens einen ersten Block und mindestens einen zweiten Block, der von dem ersten Block verschieden ist, wobei der erste Block Wiederholungseinheiten 1 umfasst,

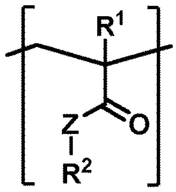
Wiederholungseinheit 1

und der zweite Block Wiederholungseinheiten 2 umfasst,

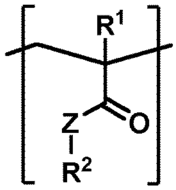
Wiederholungseinheit 2

wobei

Z für O oder NH steht,
$R^1$ für H oder $CH_3$ steht,
$R^2$ für eine aus Hydrocarbylgruppen und Ethergruppen enthaltenden Gruppen ausgewählte Gruppe steht,
$R^3$ für eine organische Gruppe mit 2 bis 4 Kohlenstoffatomen steht,
$R^4$ und $R^5$ unabhängig für eine organische Gruppe stehen, wobei $R^4$ und $R^5$ gegebenenfalls miteinander zu einer cyclischen Struktur verknüpft sind,
und wobei der erste Block mindestens zwei verschiedene Arten von Wiederholungseinheiten, die Ethergruppen umfassen, umfasst.

**2.** Blockcopolymer nach Anspruch 1, wobei der zweite Block ferner Wiederholungseinheiten 3 umfasst,

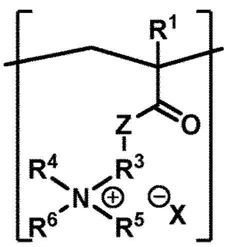
Wiederholungseinheit 3

wobei $R^6$ für eine organische Gruppe steht und $X^-$ für ein Anion steht.

**3.** Blockcopolymer nach Anspruch 1 oder 2, wobei der erste Block mindestens sechs verschiedene Arten von Wiederholungseinheiten 1 umfasst.

**4.** Blockcopolymer nach einem der vorhergehenden Ansprüche, wobei der erste Block zwischen 3 und 50 Mol-% Wiederholungseinheiten, die Ethergruppen umfassen, umfasst.

**5.** Blockcopolymer nach einem der vorhergehenden Ansprüche, wobei der erste Block aus polymerisierten Einheiten von a) Methylmethacrylat in einer Menge von 20 bis 60 Gew.-%, b) Butylmethacrylat in einer Menge von 10 bis 30 Gew.-%, c) 2-Ethylhexylmethacrylat in einer Menge von 10 bis 30 Gew.-%, d) einem oder mehreren Methacrylaten mit einem aromatischen und aliphatischen Ring in einer Menge von 3 bis 20 Gew.-% und e) zwei oder mehr Methacrylaten mit Ethergruppen in einer Menge von 3 bis 20 Gew.-%, wobei sich die Gew.-%-Anteile von a) bis e) zu 100 % summieren, besteht.

**6.** Blockcopolymer nach einem der vorhergehenden Ansprüche, wobei das Blockcopolymer eine Polydispersität im Bereich von 1,03 bis 1,80 aufweist.

**7.** Blockcopolymer nach einem der vorhergehenden Ansprüche, wobei das Blockcopolymer ein zahlenmittleres Molekulargewicht $M_n$ im Bereich von 2000 bis 20.000 g/mol aufweist.

**8.** Blockcopolymer nach einem der vorhergehenden Ansprüche, wobei der erste Block Wiederholungseinheiten umfasst, die sich von Monomeren ableiten, die aus Ethyltriglykolmethacrylat, Methyltriglykolmethacrylat, Butyldiglykolmethacrylat und Mischungen davon ausgewählt sind.

**9.** Blockcopolymer nach einem der vorhergehenden Ansprüche, wobei das Gewichtsverhältnis des ersten Blocks und des zweiten Blocks im Bereich von 90:10 bis 25:75 liegt.

**10.** Blockcopolymer nach einem der vorhergehenden Ansprüche, wobei das Blockcopolymer einen dritten Block umfasst, der von dem ersten und dem zweiten Block verschieden ist.

**11.** Blockcopolymer nach Anspruch 10, wobei sich der dritte Block zwischen dem ersten Block und dem zweiten Block befindet.

**12.** Blockcopolymer nach einem der vorhergehenden Ansprüche 1 bis 9, wobei das Blockcopolymer aus dem ersten Block und dem zweiten Block besteht.

**13.** Zusammensetzung, umfassend

(A) mindestens ein Netz- und/oder Dispergiermittel,
(B) mindestens ein Farbmittel und
(C) mindestens ein organisches Lösungsmittel,
wobei es sich bei dem Netz- und/oder Dispergiermittel um ein Blockcopolymer nach einem der vorhergehenden Ansprüche handelt.

**14.** Zusammensetzung nach Anspruch 13, wobei das Farbmittel aus Pigmenten, Farbstoffen und Mischungen davon ausgewählt ist.

**15.** Zusammensetzung nach Anspruch 13 oder 14, wobei die Zusammensetzung ferner mindestens ein alkalilösliches Harz umfasst.

**16.** Zusammensetzung nach einem der vorhergehenden Ansprüche 13 bis 15, wobei die Zusammensetzung ferner eine Komponente mit mindestens einer ethylenisch ungesättigten polymerisierbaren Gruppe umfasst.

**17.** Verfahren zur Herstellung eines Farbfilters, wobei das Verfahren die Schritte des Aufbringens der Zusammensetzung nach einem der Ansprüche 13 bis 16 auf ein Substrat und des Härtens ausgewählter Bereiche der Zusammensetzung durch Belichtung mit aktinischer Strahlung umfasst.

**18.** Verfahren nach Anspruch 17, wobei der Farbfilter in einer Flüssigkristallanzeige, einem Flüssigkristallbildschirm, einer Farbauflösungsvorrichtung oder einem Sensor enthalten ist.

## Revendications

1. Co-polymère à blocs comprenant au moins un premier bloc et au moins un deuxième bloc qui est différent du premier bloc, le premier bloc comprenant des motifs répétitifs 1,

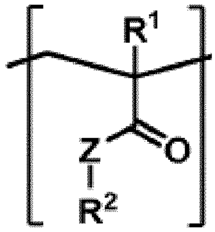
motif répétitif 1

et le deuxième bloc comprenant des motifs répétitifs 2,

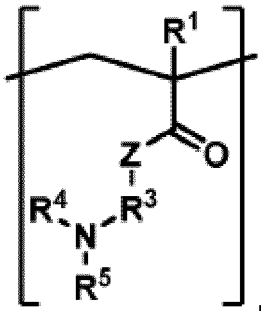
motif répétitif 2

Z représentant O ou NH,
$R^1$ représentant H ou $CH_3$,
$R^2$ représentant un groupe choisi parmi des groupes hydrocarbyle et des groupes contenant un groupe éther,
$R^3$ représentant un groupe organique possédant 2 à 4 atomes de carbone,
$R^4$ et $R^5$ représentant indépendamment un groupe organique, $R^4$ et $R^5$ étant éventuellement liés l'un à l'autre pour former une structure cyclique,
et le premier bloc comprenant au moins deux différents types de motifs répétitifs comprenant des groupes éther.

2. Co-polymère à blocs selon la revendication 1, le deuxième bloc comprenant en outre des motifs répétitifs 3

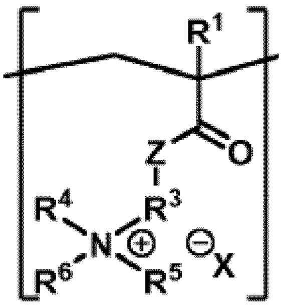
motif répétitif 3

$R^6$ représentant un groupe organique et $X^-$ représentant un anion.

3. Co-polymère à blocs selon la revendication 1 ou 2, le premier bloc comprenant au moins six différents types de motifs répétitifs 1.

4. Co-polymère à blocs selon l'une quelconque des revendications précédentes, le premier bloc comprenant entre 3 et 50 % en moles de motifs répétitifs comprenant des groupes éther.

**5.** Co-polymère à blocs selon l'une quelconque des revendications précédentes, le premier bloc étant constitué de motifs polymérisés de a) méthacrylate de méthyle en une quantité de 20 à 60 % en poids, b) méthacrylate de butyle en une quantité de 10 à 30 % en poids, c) méthacrylate de 2-éthyl-hexyle en une quantité de 10 à 30 % en poids, d) un ou plusieurs méthacrylates possédant un cycle aromatique ou aliphatique en une quantité de 3 à 20 % en poids, et e) deux ou plus de deux méthacrylates possédant des groupes éther en une quantité de 3 à 20 % en poids, les % en poids de a) à e) totalisant 100 %.

**6.** Co-polymère à blocs selon l'une quelconque des revendications précédentes, le co-polymère à blocs possédant une polydispersité dans la plage de 1,03 à 1,80.

**7.** Co-polymère à blocs selon l'une quelconque des revendications précédentes, le co-polymère à blocs possédant un poids moléculaire moyen en nombre $M_n$ dans la plage de 2 000 à 20 000 g/mole.

**8.** Co-polymère à blocs selon l'une quelconque des revendications précédentes, le premier bloc comprenant des motifs répétitifs issus de monomères choisis parmi le méthacrylate d'éthyltriglycol, le méthacrylate de méthyltriglycol, le méthacrylate de butyldiglycol, et des mélanges correspondants.

**9.** Co-polymère à blocs selon l'une quelconque des revendications précédentes, le rapport en poids du premier bloc et du deuxième bloc étant dans la plage de 90 : 10 à 25 : 75.

**10.** Co-polymère à blocs selon l'une quelconque des revendications précédentes, le co-polymère à blocs comprenant un troisième bloc, qui est différent du premier et du deuxième bloc.

**11.** Co-polymère à blocs selon la revendication 10, le troisième bloc étant situé entre le premier bloc et le deuxième bloc.

**12.** Co-polymère à blocs selon l'une quelconque des revendications précédentes 1 à 9, le co-polymère à blocs étant constitué du premier bloc et du deuxième bloc.

**13.** Composition comprenant

(A) au moins un agent mouillant et/ou dispersant,
(B) au moins une matière colorante, et
(C) au moins un solvant organique,
l'agent mouillant et/ou dispersant étant un co-polymère à blocs selon l'une quelconque des revendications précédentes.

**14.** Composition selon la revendication 13, la matière colorante étant choisie parmi des pigments, des colorants, et des mélanges correspondants.

**15.** Composition selon la revendication 13 ou 14, la composition comprenant en outre au moins une résine soluble dans un alcali.

**16.** Composition selon l'une quelconque des revendications précédentes 13 à 15, la composition comprenant en outre un composant possédant au moins un groupe polymérisable éthyléniquement insaturé.

**17.** Procédé pour la préparation d'un filtre de couleur, le procédé comprenant les étapes d'application de la composition selon l'une quelconque des revendications 13 à 16 à un substrat et le durcissement de zones choisies de la composition par exposition à un rayonnement actinique.

**18.** Procédé selon la revendication 17, le filtre de couleur étant inclus dans un affichage à cristaux liquides, un écran à cristaux liquides, un dispositif de résolution de couleur ou un capteur.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009025813 A
- US 5272201 A
- EP 2589614 A
- JP 2013053231 A
- JP H07207211 A
- JP H08259876 A
- JP H10300922 A
- JP H11140144 A
- JP H11174224 A
- JP 2000056118 A
- JP 2003233179 A
- JP H08297366 A
- JP 2001089533 A
- JP 2003089716 A
- JP 2003165830 A
- JP 2005325331 A
- JP 2001354735 A
- JP 2005126674 A
- JP 2005055814 A
- JP 2004295084 A
- JP 2005154708 A
- US 8216770 B
- JP 59152396 A
- JP 61151197 A
- JP 10300922 A
- JP 11174224 A
- JP 10039503 A
- JP 2000080068 A
- JP 4221958 A
- JP 4219756 A
- JP 3239703 A
- JP 5289335 A
- JP 6019240 A
- JP 47002528 A
- JP 54155292 A
- JP 4537377 B
- JP 48084183 A
- JP 52112681 A
- JP 58015503 A
- JP 60088005 A
- JP 59056403 A
- JP 2000069 A
- JP 57168088 A
- JP 5107761 A
- JP 5210240 A
- JP 4288818 A
- US 4588795 A